(19) Europäisches Patentamt
European Patent Office
Office européen des brevets

(11) **EP 1 096 380 A1**

(12) **EUROPEAN PATENT APPLICATION**
published in accordance with Art. 158(3) EPC

(43) Date of publication:
02.05.2001 Bulletin 2001/18

(51) Int. Cl.$^7$: **G06F 11/10**, H03M 13/01, H03M 13/09, H04L 1/00

(21) Application number: 00919165.1

(22) Date of filing: 25.04.2000

(86) International application number:
PCT/JP00/02681

(87) International publication number:
WO 00/67125 (09.11.2000 Gazette 2000/45)

(84) Designated Contracting States:
AT BE CH CY DE DK ES FI FR GB GR IE IT LI LU MC NL PT SE

(30) Priority: 28.04.1999 JP 12267399

(71) Applicants:
• MATSUSHITA ELECTRIC INDUSTRIAL CO., LTD.
Kadoma-shi, Osaka 571-8501 (JP)
• Somon, Junji
Kanazawa-shi, Ishikawa 920-0867 (JP)

(72) Inventors:
• YAMANAKA, Ryutaro
Yokohama-shi, Kanagawa 233-0001 (JP)
• TODA, Takashi
Ishikawa-gun, Ishikawa 921-8824 (JP)

(74) Representative:
Grünecker, Kinkeldey,
Stockmair & Schwanhäusser
Anwaltssozietät
Maximilianstrasse 58
80538 München (DE)

(54) **PROCESSOR**

(57) Operator 104 performs a mod2 addition between the MSB of operation data stored in operation data storage section 101 and input data stored in input data storage section 102. Operator 105 performs a mod2 addition between data obtained by shifting the operation data stored in operation data storage section 101 by 1 bit toward the MSB side and coefficients of a generator polynomial stored in generator polynomial storage section 103. Selection section 106 selects either the shift data or the operation result of operator 105 based on the operation result of operator 104 and stores the selected one in operation data storage section 101 as new operation data. This allows the DSP to efficiently process CRC operations with a small hardware investment.

FIG. 2

## Description

Technical Field

The present invention relates to an arithmetic processing unit mounted in radio communication equipment, etc. that carries out CRC operations.

Background Art

In radio communications, in order to correct bit errors that occur during radio transmission, the transmitting side applies coding processing for error correction to data, while the receiving side applies decoding processing to error correction codes.

However, in the case where a propagation environment is poor and errors occur too frequently, it is difficult to completely correct errors through only the error correction processing above. Thus, in a mobile radio communication, error check processing is carried out together with the error correction processing above to detect whether errors remain or not. Typical error check processing is CRC (Cyclic Redundancy Check).

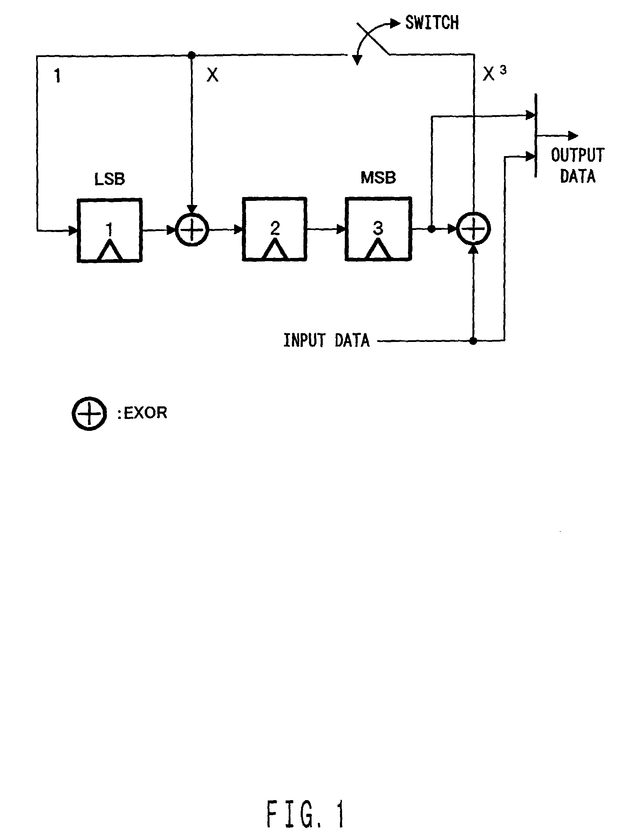

Hereinafter, CRC will be explained. First, a CRC operation coding circuit will be explained. FIG.1 is a CRC operation coding circuit diagram when a generator polynomial is assumed to be $G(X)= 1+X+X^3$.

As shown in FIG.1, the number of shift register stages in the CRC operation coding circuit is equal to the highest degree of the generator polynomial. The boundary of each flip flop (hereinafter referred to as "FF") corresponds to each degree of the generator polynomial and the degree increases in the ascending order from LSB (Least Significant Bit) to MSB (Most Significant Bit).

Furthermore, in the CRC operation coding circuit, if coefficients of the first and higher degrees of the generator polynomial are [1], an EXOR (exclusive OR element) is inserted in each FF boundary corresponding to the degree.

Then, a CRC coding operation and CRC decoding operation will be explained.

In the CRC coding operation, as a first step. contents of all shift registers are reset to "0". Then, as a second step, a mod2 addition (modulo 2 - adder: 1-digit binary addition) with the MSB of the shift registers is carried out on 1 bit of input data. Then, as a third step, the result of the mod2 addition in the second step is shifted into the shift registers and input to the EXOR of other than the highest degree, a mod2 addition is carried out with each FF output and the result is input to the FF in the next stage.

The processing in the second step and processing in the third step above are repeated until no more input bit remains and the content finally obtained of the shift registers is the CRC coding result and added to the input data as a redundant bit.

On the other hand, the CRC decoding operation performs an operation similar to the CRC coding operation above and compares the resulting content of the shift register and the received redundant bit. In the case where the comparison result shows that the resulting content of the shift register and the received redundant bit match, it IS decided that no error has been detected and in the case where the resulting content of the shift register and the received redundant bit do not match, it is decided that an error has been detected.

Here, the generator polynomial and the number of redundant bits, that is, the number of shift register stages vary depending on the system and even in a same system, a plurality of types may be used according to different purposes.

Therefore, rather than incorporating dedicated hardware corresponding to a plurality of types of CRC operations, processing signals in a programmable manner using a DSP (digital signal processor) would contribute to a reduction in the size and weight of the apparatus. Moreover, to achieve a reduction in the size, weight and cost of a portable terminal, the area processed by a dedicated LSI so far is now being implemented on a single chip by means of DSP processing.

Implementing CRC operations using a conventional DSP requires the following operations:

First, in a first operation, input data is loaded and stored in a first register.

Then, in a second operation, the highest-degree bit position is extracted from a second register that stores the operation result and stored in a third register.

Then, in a third operation, the second register is logically shifted by 1 bit toward the MSB side and the result is stored in the second register.

Then, in a fourth operation, a mod2 addition between the first register and third register is carried out.

Then, in a fifth operation, if the fourth operation results in "0", the content of the second register is not updated and if the fourth operation results in "1", the result of a mod2 addition between the second register and the fourth register that stores the generator polynomial in the second register.

As described above, the conventional DSP requires at least 5 operations per 1 bit of input data to execute a CRC operation and if each operation is executed in 1 machine cycle, at least 5 machine cycles are required. In fact, since a conditional branch of the fifth operation causes a branch penalty due to a DSP pipeline, the number of machine cycles increases by that amount. The operation quantity of the DSP required for a CRC operation increases in proportion to machine cycles required.

Here, in recent years, the transmission bit rate in a mobile radio communication tends to increase. The operation quantity of the DSP required for a CRC operation increases in proportion to the bit rate.

As the operation quantity of the DSP increases, it becomes more difficult to continue to operate a battery of the portable terminal for a long time. Moreover, the operation quantity of the DSP will exceed the throughput capacity of an existing DSP, making implementation of a circuit on a single chip by the DSP impossible. Providing a more sophisticated DSP to increase the operation quantity will cause a cost increase of the DSP itself, and as a result it will be impossible to implement a low cost portable terminal.

Disclosure of Invention

It is a primary object of the present invention to provide an arithmetic processing unit that will efficiently process CRC operations using a DSP with a small hardware investment.

This object is attained by storing as new operation data either the operation result of a mod2 addition between data obtained by shifting operation data by 1 bit toward the MSB side and coefficients of a generator polynomial or data obtained by shifting operation data by 1 bit toward the MSB side based on the operation result of a mod2 addition between operation data and input data.

Brief Description of Drawings

FIG. 1 is a coding circuit diagram for CRC operations of generator polynomial $G(X)= 1+X+X^3$ ;
FIG.2 is a block diagram showing a configuration of an arithmetic processing unit according to Embodiment 1 of the present invention;
FIG.3 is a flow chart showing a processing operation of the arithmetic processing unit according to Embodiment 1 of the present invention;
FIG.4 is a block diagram showing a configuration of an arithmetic processing unit according to Embodiment 2 of the present Invention;
FIG.5 is a block diagram showing a configuration of an arithmetic processing unit according to Embodiment 3 of the present invention;
FIG.6 Is a block diagram showing a configuration of an arithmetic processing unit according to Embodiment 4 of the present invention; and
FIG.7 is a block diagram showing a configuration of an arithmetic processing unit according to Embodiment 5 of the present invention.

Best Mode for Carrying out the Invention

With reference now to the attached drawings, embodiments of the present invention will be explained in detail below.

(Embodiment 1)

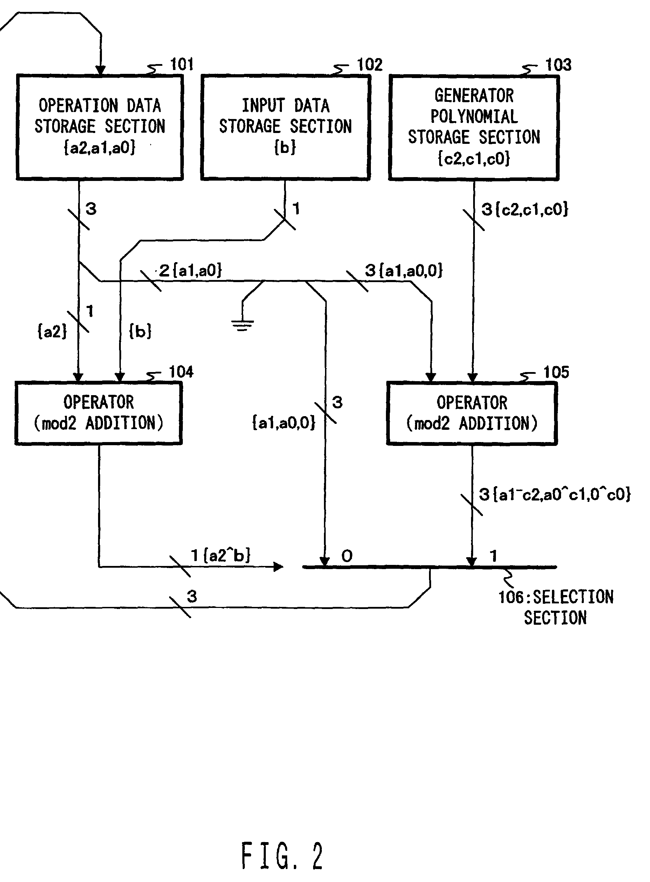

FIG.2 is a block diagram showing a configuration of an arithmetic processing unit according to this embodiment.

In FIG.2, the arithmetic processing unit according to this embodiment is mainly configured by operation data storage section 101 that stores operation data, input data storage section 102 that stores input data, generator polynomial storage section 103 that stores coefficients of a generator polynomial, operators 104 and 105 that carry out mod2 additions and selection section 106 that outputs either one of the two data items entered.

Hereinafter, processing carried out by each component will be explained more specifically taking a case of a 3-bit CRC as an example.

In the case of an N-bit CRC, operation data storage section 101 and generator polynomial storage section 103 are configured by at least N bits and operator 105 must have a capacity for performing at least N-bit mod2 additions. For example, In the case of the 3-bit CRC, operation data storage section 101 and generator polynomial storage section 103 are configured by at least 3 bits and operator 105 carries out mod2 additions of at least 3 bits.

In the case where operation data stored in operation data storage section 101 is assumed to be {a2, a1, a0} with the MSB first, a2 corresponds to the boundary between the 3rd degree and 2nd degree, a1 corresponds to the boundary between the 2nd degree and 1st degree and a0 corresponds to the boundary between the 1st degree and 0th degree.

From input data storage section 102, input data, which is a CRC target, is output from the first 1 bit at a time every 1 machine cycle. Hereinafter, suppose the first 1 bit at each point in time of input data stored in input data storage section 102 is {b}.

In generator polynomial storage section 103, coefficients of terms of the (highest degree - 1)th or lower degrees are stored in descending order with the highest degree being the MSB. For example, in the case where the order of coefficients of the generator polynomial with MSB first is assumed to be {c2, c1, c0} and $G(X)= 1+X+X^3$ is used as the generator polynomial, {c2, c1, c0}={0, 1, 1} is stored.

Operator 104 carries out a mod2 addition between MSB {a2} of operation data stored in operation data storage section 101 and input data {b} stored in input data storage section 102 and 1-bit operation result {a2^b} is output to selection section 106.

Operator 105 carries out a mod2 addition between data {a1, a0, 0} obtained by shifting the operation data stored in operation data storage section 101 by 1 bit toward the MSB side (hereinafter referred to as "shift data") and coefficients {c2, c1, c0} of the generator polynomial stored in generator polynomial storage section 103 and the operation result {a1^c2, a0^c1, 0^c0} is output to selection section 106.

Selection section 106 selects either shift data {a1, a0, 0} or operation result {a1^c2, a0^c1, 0^c0} of operator 105 based on operation result {a2^b} of operator 104 and stores the selected one in operation data storage section 101 as new operation data {a2, a1, a0}. For example, if the operation result of operator 104 is "0", selection section 106 stores the shift data in operation data storage section 101 and if the operation result of operator 104 is "1" selection section 106 stores the operation result of operator 105 in operation data storage section 101.

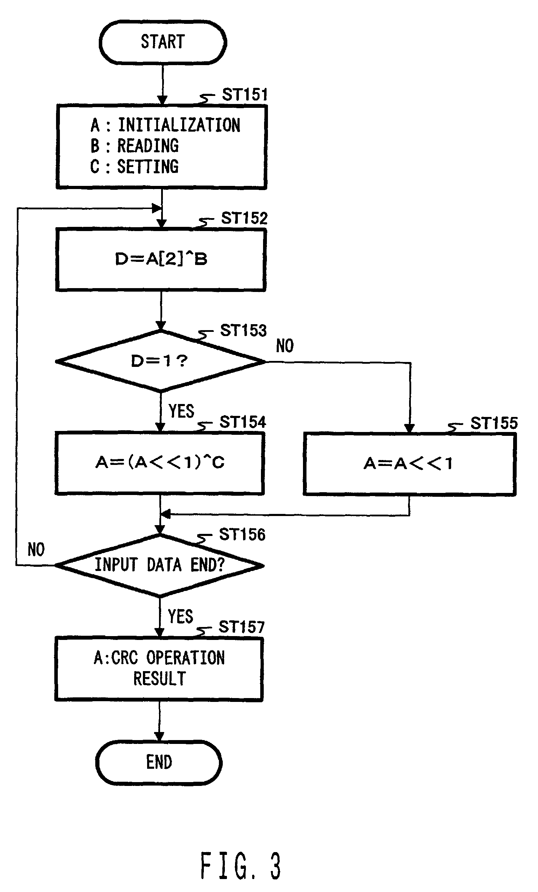

Then, the processing operation of the arithmetic processing unit according to this embodiment will be explained using the flow chart in FIG.3. FIG.3 shows a case with a 3-bit CRC and expresses operation data as A[2:0], the first 1 bit in each point in time of input data as B and the coefficients of the generator polynomial as C[2:0].

First, in ST151, operation data A[2:0] stored in storage section 101 is initialized to A(0,0,0), etc. Then, input data, which is a CRC target, is loaded to storage section 102. Furthermore, coefficients C[2:0] of the generator polynomial are set in storage section 103. For example, in the case of generator polynomial $G(X)= 1+X+X^3$, C(0,1,1) results.

Then, in ST152, operator 104 carries out a mod2 addition: D=A[2]^B between A[2] and B, and operation result D of 1 bit is output to selection section 106.

Then, in ST153 to ST155, selection section 106 performs update processing of A based on the value of D. That is, in the case of D=0, processing: A=<<1 of designating shift data A<<1 as new A is performed and in the case of D=1, processing: A=(A<<1)¯C of designating the result of a mod2 addition between A<<1 carried out by operator 104 and C as new operation data is performed.

Then, processing from ST152 to ST155 is repeated until it is decided in ST156 that no more input data remains and A, which is finally obtained in ST157, is the operation result of the 3-bit CRC.

Thus, repeatedly executing a CRC operation in 1 machine cycle per 1 bit of input data makes it possible to efficiently carry out CRC operations by the DSP, implement the DSP on a single chip, reduce the size, weight and cost of the portable terminal and extend the life of the battery.

(Embodiment 2)

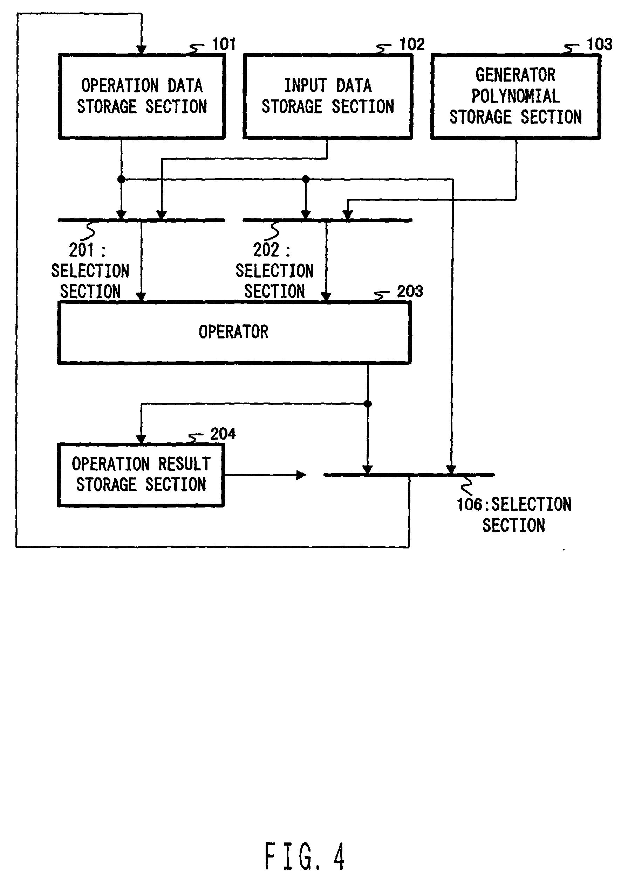

FIG.4 is a block diagram showing a configuration of an arithmetic processing unit according to this embodiment. In FIG.4, the components common to those in FIG.2 will be assigned the same reference numerals as those in FIG.2 and explanations thereof will be omitted.

Compared with the arithmetic processing unit shown in FIG.2, the arithmetic processing unit shown In FIG.4 adopts a configuration with selection sections 201 and 202, operator 203 and operation result storage section 204 added instead of operators 104 and 105.

The arithmetic processing unit shown in FIG.4 assigns the processing by two operators 104 and 105 in the arithmetic processing unit shown in FIG.2 to operator 203 and executes a CRC operation in 2 machine cycles per 1 bit. Selection section 201 and selection section 202 switch data input to operator 203 in the 1st machine cycle and 2nd machine cycle.

Hereinafter, the operation of each component in each machine cycle will be explained.

In the 1st machine cycle, selection section 201 outputs the input data stored in input data storage section 102 to operator 203. Selection section 202 outputs the MSB of the operation data stored in operation data storage section 101 to operator 203. Operator 203 carries out a mod2 addition between the input data and the MSB of operation data and stores the operation result in operation result storage section 204.

In the 2nd machine cycle, selection section 201 outputs the operation data stored in operation data storage section 101 to operator 203. Selection section 202 outputs coefficients of a generator polynomial stored in generator polynomial storage section 103 to operator 203. Operator 203 carries out a mod2 addition between the operation data and the coefficients of the generator polynomial and outputs the operation result to selection section 106.

Furthermore, in the 2nd machine cycle, selection section 106 selects either the shift data or the operation result of operator 203 based on the operation result stored in operation result storage section 204 and stores the selected one in operation data storage section 101 as new operation data. For example, if the operation result stored in operation result storage section 204 is "0", selection section 106 stores the shift data in operation data storage section 101 and if the operation result is "1", selection section 106 stores the operation result of operator 105 in operation data storage section 101.

Thus, carrying out CRC operations in 2 machine cycles per 1 bit and carrying out two mod2 additions using one operator can make the configuration of the apparatus simpler than Embodiment 1. Furthermore, this embodiment can perform CRC operations by the DSP more efficiently than conventional units and make it possible to implement the DSP on a single chip, reduce the size, weight and cost of the portable terminal and extend the life of the battery.

Furthermore, by operating the arithmetic processing unit on 2-phase clocks, configuring operation result storage section 204 by a latch (latch circuit), performing latch on the 1st-phase clock, carrying out processing of each component corresponding to the 1st cycle above on the 1st-phase clock and carrying out processing of each component corresponding to the 2nd cycle above on the 2nd-phase clock, the arithmetic processing unit according to this embodiment can execute CRC operations in a time equivalent to 1 machine cycle per 1 bit of input data.

(Embodiment 3)

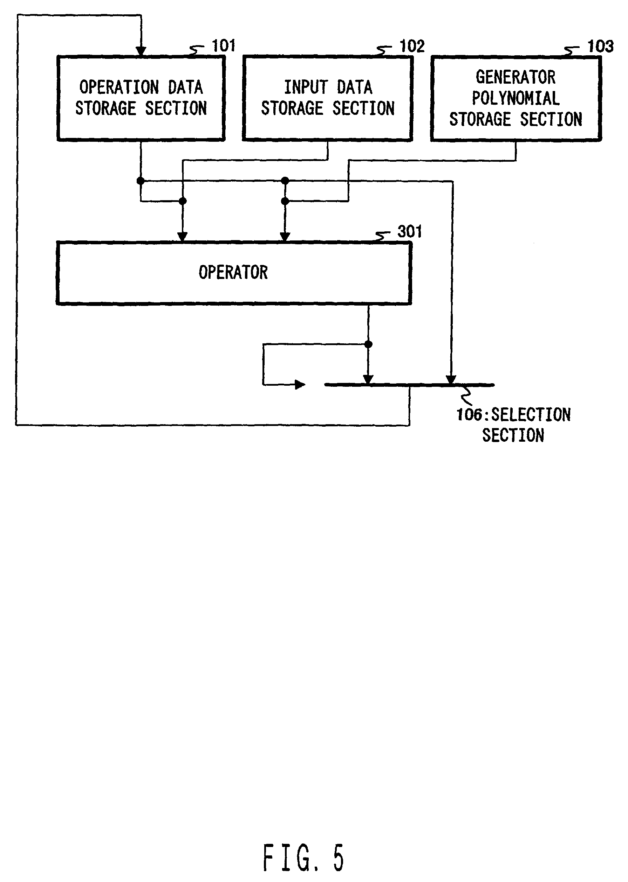

FIG.5 is a block diagram showing a configuration of an arithmetic processing unit according to this embodiment. In FIG.5, the components common to those in FIG.2 will be assigned the same reference numerals as those in FIG.2 and explanations thereof will be omitted.

Compared with the arithmetic processing unit shown in FIG.2, the arithmetic processing unit shown in FIG.5 adopts a configuration with operator 301 added instead of operators 104 and 105.

The arithmetic processing unit shown in FIG.5 assigns the processing by two operators 104 and 105 in the arithmetic processing unit shown in FIG.2 to operator 301 and executes a CRC operation in 1 machine cycle per 1 bit by carrying out an operation after merging two kinds of data.

Hereinafter, processing carried out by each component will be explained more specifically taking a case of a 3-bit CRC as an example.

In the case of a 3-bit CRC, operation data storage section 101 and generator polynomial storage section 103 are configured by at least 3 bits and operator 301 performs a mod2 addition of at least 4 bits.

Suppose operation data stored in operation data storage section 101 is $A[2:0]$, the first 1 bit at each point in time of Input data stored in input data storage section 102 is B and coefficients of the generator polynomial stored in generator polynomial storage section 103 are $C[2:0]$.

One of the data entered in operator 301 is values $\{A[1], A[0], 0, B\}$ resulting from a merge between data $\{A[1], A[0], 0\}$ obtained by logically shifting the operation data stored in operation data storage section 101 by 1 bit toward the MSB side and input data $\{B\}$ of 1 bit stored in input data storage section 102. The other is values $\{C[2], C[1], C[0], A[2]\}$ resulting from a merge between coefficients $\{C[2], C[1], C[0]\}$ of the generator polynomial stored in generator polynomial storage section 103 and MSB $\{A[2]\}$ of the operation data stored in operation data storage section 101.

Operator 301 carries out a mod2 addition between $\{A[1], A[0], 0, B\}$ and $\{C[2], C[1], C[0], A[2]\}$ and outputs the addition result to selection section 106.

Selection section 106, based on LSB $\{A[2]\text{^}B\}$ of the operation result of operator 301, selects either shift data $\{A[1], A[0], 0\}$ or operation result $\{A[1]\text{^}C[2], A[0]\text{^}C[1], 0\text{^}C[0]\}$ other than the LSB of operator 301, and stores the selected one in operation data storage section 101 as new operation data $\{A[2:0]\}$. For example, if $\{A[2]\text{^}B\}$ is "0", selection section 106 stores $\{A[1], A[0], 0\}$ in operation data storage section 101 and if $\{A[2]\text{^}B\}$is "1", selection section 106 stores $\{A[1]\text{^}C[2], A[0]\text{^}C[1], 0\text{^}[0]\}$ in operation data storage section 101.

As shown above, performing operations after merging two kinds of data and thereby using only one operator makes it possible to carry out CRC operations in 1 machine cycle per 1 bit and make the configuration of the apparatus simpler than Embodiment 1.

(Embodiment 4)

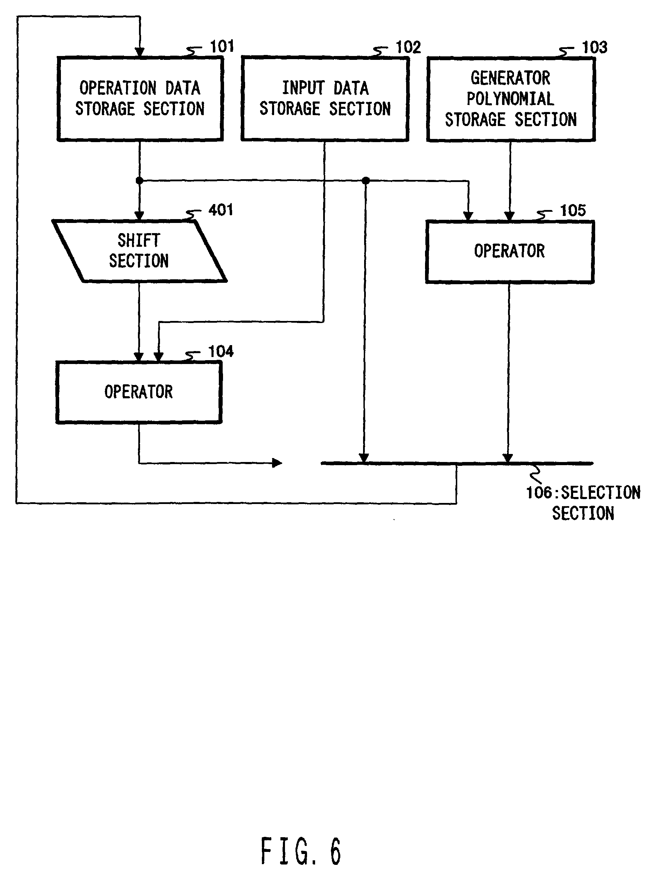

FIG.6 is a block diagram showing a configuration of an arithmetic processing unit according to this embodiment. In FIG.6, the components common to those in FIG.2 will be assigned the same reference numerals as those in FIG.2 and explanations thereof will be omitted.

Compared to the arithmetic processing unit shown in FIG.2, the arithmetic processing unit shown in FIG.6 adopts a configuration with shift section 401 added.

Shift section 401 logically shifts operation data stored in operation data storage section 101 by a value (highest degree - 1) of the generator polynomial toward the LSB side and outputs the LSB value to operator 104.

This makes it possible to handle CRC operations of arbitrary bits.

(Embodiment 5)

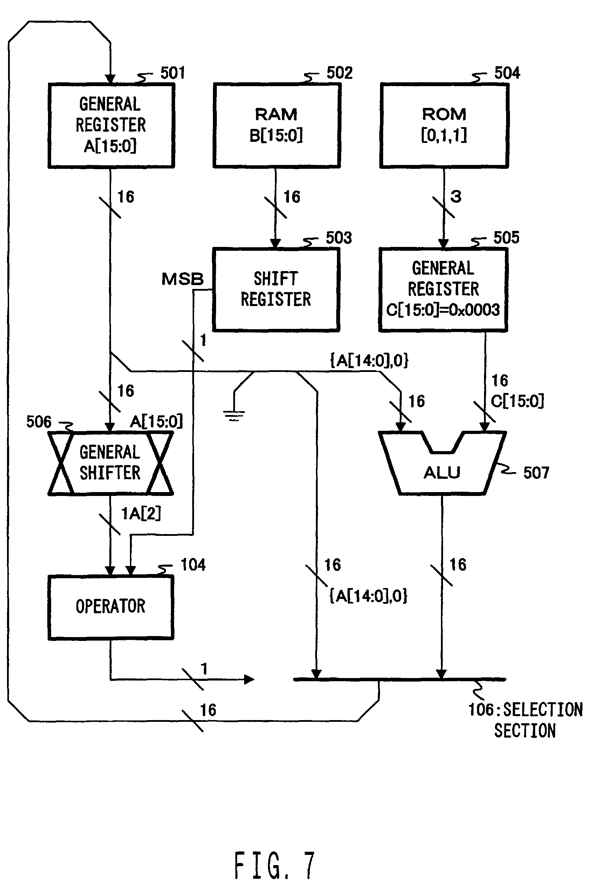

FIG.7 is a block diagram showing a configuration of an arithmetic processing unit according to this embodiment. In FIG.7, the components common to those in FIG.6 will be assigned the same reference numerals as those in FIG 6 and explanations thereof will be omitted.

Compared to the arithmetic processing unit shown in FIG. 6, the arithmetic processing unit shown in FIG.7 configures operation data storage section 101 by general register 501, configures input data storage section 102 by RAM 502 and shift register 503, configures generator polynomial storage section 103 by ROM 504 and general register 505, configures shift section 401 by general shifter 506 and configures operator 105 by ALU (Arithmetic Logic Unit) 507.

Hereinafter, processing carried out by each component will be explained more specifically taking a case where $G(X)= 1+X+X^3$ is used as a generator polynomial and a 3-bit CRC is implemented using a 16-bit fixed point DSP as an example.

Operation data $A[15:0]$ is stored in general register 501 and initial value $A[15:0]=0\times0000$ is set before a CRC operation is carried out.

Input data is stored in RAM 502 in units of 16 bits, MSB-first for several words and 1-word input data $B[15:0]$ is transferred to shift register 503 before a CRC operation is carried out.

When a CRC operation is carried out, shift register 503 outputs the MSB value to operator 104 once every machine cycle and shifts up at the same time.

At least one coefficient of a generator polynomial is stored in ROM 504 and the generator polynomial specified by the DSP beforehand is transferred to general register 505 before a CRC operation is carried out. In the case of this embodiment, {0,1,1} is stored in ROM 504.

In the case where the output of ROM 504 falls below 16 bits, general register 505 fills the remaining higher bits with "0"s on the lower-degree side of the generator polynomial. In the case of a 3-bit CRC, general register 505 stores C[15:0]=0×0003.

General shifter 506 logically shifts operation data A[15:0] stored in general register 501 by the value of (highest degree - 1) of the generator polynomial toward the LSB side and outputs the LSB value to operator 104. In this embodiment, general shifter 506 outputs A[2].

Shift data {A[14:0],0}, which is a value obtained by logically shifting the operation data stored in general register 501 by 1 bit toward the MSB side, is always input to ALU 507 with fixed wiring. Moreover, coefficients C[15:0] of the generator polynomial stored in general register 505 are input to ALU 507. ALU 507 carries out a mod2 addition between {A[14:0],0} and C[15:0] and outputs the operation result to selection section 106.

The operation result of ALU 507 and shift data are always input to selection section 106 with fixed wiring. Based on the operation result of operator 104, selection section 106 selects either the operation result of ALU 507 or shift data and stores the selected one in general register 501 as new operation data. For example, if the operation result of operator 104 is "0" selection section 106 stores shift data in general register 501 and if the operation result of operator 104 is "1", selection section 106 stores the operation result of ALU 507 in general register 501.

Here, general registers 501 and 505 can store results of operations other than CRC operations in the process.

Shift register 503 can also be used for DSP instructions other than CRC operations such as division instruction.

When executing shift operation instructions other than a CRC operation, general shifter 506 acquires data from a general register group or memory (RAM or ROM), etc., performs a shift operation and writes the operation results in a general register or memory, etc.

When executing ALU operation instructions other than a CRC operation, ALU 507 acquires data from a general register group or memory (RAM or ROM), etc., performs ALU operation and writes the operation results in a general register or memory, etc.

Thus, applying an appropriate general register, shift register, general shifter and ALU, etc. of the DSP to a CRC operation can further reduce the chip area and reduce the cost when the arithmetic processing unit is implemented with an LSI.

In the embodiments above, the higher-degree terms of the generator polynomial are stored on the MSB side, it is also possible to store those terms on the LSB side and add changes thereto accordingly.

Furthermore, incorporating any one of the arithmetic processing units according to the embodiments above in a channel decoding section of a radio communication base station apparatus or terminal apparatus can form a channel coding section, channel decoding section and timing control section, etc. on single-chip DSP software, making it possible to reduce the number of parts in the apparatus, reduce the size, weight or cost of the apparatus.

As described above, the arithmetic processing unit of the present invention can repeatedly execute CRC operations in 1 or 2 machine cycles per 1 bit of input data, and therefore can perform CRC operations by the DSP efficiently, implement the DSP on a single-chip, reduce the size, weight and cost of the portable terminal and extend the life of the battery.

This application is based on the Japanese Patent Application No.HEI 11-122673 filed on April 28, 1999, entire content of which is expressly incorporated by reference herein.

**Claims**

1. An arithmetic processing unit comprising:

   first operating means for performing a binary addition between a most significant bit of operation data stored in a first memory and input data stored in a second memory;
   second operating means for performing a binary addition between shift data obtained by shifting said operation data by 1 bit toward the most significant bit side and coefficients of a generator polynomial stored in a third memory; and
   selecting means for selecting either the operation result of said second operating means or said shift data based on the operation result of said first operating means and storing in said first memory as new operation data.

2. An arithmetic processing unit comprising:

   third operating means that performs a first operation, which is a binary addition between a most significant bit of operation data stored in a first memory and input data stored in a second memory and performs a second operation, which is a binary addition between shift data obtained by shifting said operation data by 1 bit toward the most significant bit side and coefficients of a generator polynomial stored in a third memory; and

selecting means for selecting either the operation result of said second operation or said shift data based on the operation result of said first operation and storing in said first memory as new operation data.

3. The arithmetic processing unit according to claim 2, wherein said selecting means retains the operation result of the first operation in a fourth memory until the operation result of the second operation is input.

4. An arithmetic processing unit comprising:

fourth operating means for performing a binary addition between a value resulting from a merge between shift data obtained by shifting operation data stored in a first memory by 1 bit toward the most significant bit side and input data stored in a second memory and a value resulting from a merge between coefficients of a generator polynomial stored in a third memory and the most significant bit of said operation data; and

selecting means for selecting either the result of the binary addition between said shift data and the coefficients of the generator polynomial or said shift data based on the result of the binary addition between the input data and the most significant bit of the operation data and storing in said first memory as new operation data.

5. An arithmetic processing unit comprising:

fourth operating means for performing a binary addition between shift data obtained by shifting operation data stored in a first memory by 1 bit toward the most significant bit side and a value resulting from a merge between coefficients of a generator polynomial stored in a third memory and input data stored in a second memory; and

selecting means for selecting either the result of the binary addition between said shift data and the coefficients of the generator polynomial or said shift data based on the result of the binary addition between the input data and the most significant bit of the operation data and storing in said first memory as new operation data.

6. The arithmetic processing unit according to claim 1, further comprising shifting means for shifting the most significant bit of the operation data stored in the first memory to a predetermined position.

7. The arithmetic processing unit according to claim 6, wherein the shifting means Includes a DSP general shifter as a component.

8. The arithmetic processing unit according to claim 1, wherein at least one of the operating means includes an ALU as a component.

9. The arithmetic processing unit according to claim 1, wherein at least one of the memories includes a DSP general register as a component.

10. The arithmetic processing unit according to claim 1, wherein at least one of the memories includes a shift register as a component.

11. A radio communication terminal apparatus having an arithmetic processing unit, said arithmetic processing unit comprising:

first operating means for performing a binary addition between a most significant bit of operation data stored in a first memory and input data stored in a second memory;

second operating means for performing a binary addition between shift data obtained by shifting said operation data by 1 bit toward the most significant bit side and coefficients of a generator polynomial stored in a third memory; and

selecting means for selecting either the operation result of said second operating means or said shift data based on the operation result of said first operating means and storing in said first memory as new operation data.

12. A radio communication base station apparatus having an arithmetic processing unit, said arithmetic processing unit comprising:

first operating means for performing a binary addition between a most significant bit of operation data stored in a first memory and input data stored in a second memory;

second operating means for performing a binary addition between shift data obtained by shifting said operation data by 1 bit toward the most significant bit side and coefficients of a generator polynomial stored in a third memory; and

selecting means for selecting either the operation result of said second operating means or said shift data based on the operation result of said first operating means and storing in said first memory as new operation data.

13. A mechanically readable recording medium that records a program implementing an arithmetic processing unit by software, said arithmetic processing unit comprising:

first operating means for performing a binary addition between a most significant bit of operation data stored in a first memory and input data stored in a second memory;
second operating means for performing a binary addition between shift data obtained by shifting said operation data by 1 bit toward the most significant bit side and coefficients of a generator polynomial stored in a third memory; and
selecting means for selecting either the operation result of said second operating means or said shift data based on the operation result of said first operating means and storing in said first memory as new operation data.

FIG. 1

FIG. 2

START

ST151

A : INITIALIZATION
B : READING
C : SETTING

ST152

D=A[2]^B

ST153

D=1?  NO

YES  ST154

A=(A<<1)^C

ST155

A=A<<1

ST156

NO

INPUT DATA END?

YES  ST157

A:CRC OPERATION
RESULT

END

FIG. 3

FIG. 4

**FIG. 5**

FIG. 6

FIG. 7

# INTERNATIONAL SEARCH REPORT

| | International application No. |
|---|---|
| | PCT/JP00/02681 |

**A. CLASSIFICATION OF SUBJECT MATTER**
Int.Cl⁷ G06F11/10, H03M13/01, H03M13/09, H04L1/00

According to International Patent Classification (IPC) or to both national classification and IPC

**B. FIELDS SEARCHED**

Minimum documentation searched (classification system followed by classification symbols)
Int.Cl⁷ G06F11/10, H03M13/00-13/09, H04L1/00

| Documentation searched other than minimum documentation to the extent that such documents are included in the fields searched | | | |
|---|---|---|---|
| Jitsuyo Shinan Koho | 1922-1996 | Toroku Jitsuyo Shinan Koho | 1994-2000 |
| Kokai Jitsuyo Shinan Koho | 1971-2000 | Jitsuyo Shinan Toroku Koho | 1996-2000 |

Electronic data base consulted during the international search (name of data base and, where practicable, search terms used)
JOIS (JICST)

**C. DOCUMENTS CONSIDERED TO BE RELEVANT**

| Category* | Citation of document, with indication, where appropriate, of the relevant passages | Relevant to claim No. |
|---|---|---|
| Y | JP, 51-132048, A (Mitsubishi Electric Corporation), 16 November, 1976 (16.11.76), Full text; Figs. 1 to 8 (Family: none) | 1-4, 6-13 |
| A | JP, 7-50596, A (Matsushita Electric Ind. Co., Ltd.), 21 February, 1995 (21.02.95), Full text; Figs. 1 to 14 (Family: none) | 1-4, 6-13 |

| ☐ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 17 July, 2000 (17.07.00) | 01 August, 2000 (01.08.00) |

| Name and mailing address of the ISA/ | Authorized officer |
|---|---|
| Japanese Patent Office | |
| Facsimile No. | Telephone No. |

Form PCT/ISA/210 (second sheet) (July 1992)

16

## INTERNATIONAL SEARCH REPORT

| International application No. |
|---|
| PCT/JP00/02681 |

---

**Box I    Observations where certain claims were found unsearchable (Continuation of item 1 of first sheet)**

This international search report has not been established in respect of certain claims under Article 17(2)(a) for the following reasons:

1. ☐ Claims Nos.:
   because they relate to subject matter not required to be searched by this Authority, namely:

2. ☒ Claims Nos.: 5
   because they relate to parts of the international application that do not comply with the prescribed requirements to such an extent that no meaningful international search can be carried out, specifically:

   The structure, function, and effect of the processor defined in claim 5 is not described nor suggested in the description and drawings.

3. ☐ Claims Nos.:
   because they are dependent claims and are not drafted in accordance with the second and third sentences of Rule 6.4(a).

---

**Box II    Observations where unity of invention is lacking (Continuation of item 2 of first sheet)**

This International Searching Authority found multiple inventions in this international application, as follows:

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

---

**Remark on Protest**    ☐    The additional search fees were accompanied by the applicant's protest.

☐    No protest accompanied the payment of additional search fees.

---

Form PCT/ISA/210 (continuation of first sheet (1)) (July 1992)